# EUROPEAN PATENT APPLICATION

(11) **EP 4 730 486 A1**
(43) Date of publication of application: **22.04.2026**
(21) Application number: 25209040.2
(22) Date of filing: 16.10.2025
(51) Int. Cl.: H01M 10/647, H01M 10/6551, H01M 10/6554, H01M 10/6563, H01M 50/209

(54) **HOUSING ASSEMBLY, ELECTRICAL MODULE, AND ENERGY STORAGE DEVICE**

(30) Priority: 16.10.2024 CN 202411448473
(71) Applicant: Xiamen Ampack Technology Limited, Xiamen City, Fujian Province, 361000 (CN)
(72) Inventor: LI, Jing, Xiamen City, Fujian Province, China, 361000 (CN); BAI, Huaiming, Xiamen City, Fujian Province, China, 361000 (CN)
(74) Representative: Icosa

(57) **Abstract**

A housing assembly (1) includes a housing (10) and a fan (20) disposed on the housing (10); The housing (10) includes a front wall (11) and a rear wall (12) disposed opposite to each other along a first direction (X), a first sidewall (13) and a second sidewall (14) disposed opposite to each other along a second direction (Y), and a top wall (15) and a bottom wall (16) disposed opposite to each other along a third direction (Z),The top wall (15) includes a first opening (151), and the first sidewall (13) includes a second opening (131). The housing (10) includes a first accommodation space (17) and an air duct (18). The air duct (18) communicates with an external space of the housing (10), the first opening (151), and the second opening (131). The fan (20) is configured to drive an airflow into the air duct (18) through one of the first opening (151) or the second opening (131), and out of the air duct (18) through the other of the first opening (151) or the second opening (131).

## Description

### TECHNICAL FIELD

This application relates to the field of energy storage, and in particular, to a housing assembly, an electrical module, and an energy storage device.

### BACKGROUND

With increased global support for the development of new energy technologies, various energy storage-related technologies have been widely applied. Batteries, electrical components, and other elements in an energy storage device are sensitive to temperature. Therefore, heat dissipation of the energy storage device has long been a focus of research in the industry.

### SUMMARY

This application provides a housing assembly, an electrical module, and energy storage device to improve the heat dissipation effect.

According to a first aspect, this application provides a housing assembly. The housing assembly includes a housing and a fan disposed on the housing. The housing includes a front wall and a rear wall disposed opposite to each other along a first direction, a first sidewall and a second sidewall disposed opposite to each other along a second direction, and a top wall and a bottom wall disposed opposite to each other along a third direction, and the first direction, the second direction, and the third direction are perpendicular to each other. The top wall includes a first opening, and the first sidewall includes a second opening. The housing includes a first accommodation space and an air duct. Along the first direction, the first accommodation space is located between the front wall and the rear wall. The air duct is located on one side of the rear wall, the one side of the rear wall being a side facing away from the first accommodation space. The air duct communicates with an external space of the housing, the first opening, and the second opening. The fan is configured to drive an airflow into the air duct through one of the first opening or the second opening, and out of the air duct through the other of the first opening or the second opening. Most of the airflow driven by the fan into the air duct is reversed and then flows out of the air duct, thereby expanding the ventilation range of the airflow, increasing the contact area between the airflow and the rear wall, and improving the heat dissipation effect within the first accommodation space. The fan is suitable for dissipating heat for components arranged in various manners within the first accommodation space, and is widely applicable. Furthermore, the heat in the first accommodation space can be naturally dissipated out of the housing through the rear wall and the air duct, thereby improving the heat dissipation effect during failure or a turned-off state of the fan.

In one or more optional embodiments, the air duct includes a plurality of first sub-ducts. The housing assembly includes a plurality of heat dissipation fins disposed on the rear wall. The plurality of heat dissipation fins are spaced apart along the second direction. A first sub-duct is formed between two adjacent heat dissipation fins. The heat dissipation fins are disposed between the top wall and the bottom wall. Along the third direction, a clearance is formed between the heat dissipation fins and the bottom wall. The clearance communicates the first sub-duct with the second opening. The heat dissipation fins can increase the heat dissipation area, thereby improving the heat dissipation efficiency and the heat dissipation effect. The airflow within the air duct can flow through each heat dissipation fin, thereby expanding the ventilation range of the airflow and improving the heat dissipation uniformity and the heat dissipation effect.

In one or more optional embodiments, the first sub-duct extends along the third direction. The extension direction of the first sub-duct is consistent with the natural upward trend of a hot air flow, thereby reducing the resistance generated by the heat dissipation fins to the airflow, increasing the air flow rate, and consequently improving the heat dissipation efficiency and the heat dissipation effect.

In one or more optional embodiments, the clearances formed between the plurality of heat dissipation fins and the bottom wall communicate with each other.

In one or more optional embodiments, the space below the plurality of first sub-ducts and the clearances formed between the plurality of heat dissipation fins and the bottom wall together form a second sub-duct. The second sub-duct extends to the first sidewall along a direction opposite to the second direction, and communicates with the second opening.

In one or more optional embodiments of the above technical solution, when viewed along the third direction, the first opening intersects the first sub-duct, thereby reducing the entry of impurities into the first sub-duct and alleviating the degree of dust accumulation on the heat dissipation fins.

In one or more optional embodiments, a dimension of the clearance formed between the plurality of heat dissipation fins and the bottom wall along the second direction assumes a tendency to decreases gradually. The clearance formed between the heat dissipation fin near the second opening and the bottom wall is relatively large, and the clearance formed between the heat dissipation fin farther away from the second opening and the bottom wall is relatively small, thereby reducing the resistance generated by the heat dissipation fin near the first sidewall to the airflow, allowing the fan-driven airflow to flow along the second direction toward each first sub-duct, and improving the heat dissipation uniformity and the heat dissipation effect. Furthermore, the above arrangement can maximize the area of the heat dissipation fins farther away from the first sidewall and improve the heat dissipation effect.

In one or more optional embodiments, the rear wall includes a main portion and a first protrusion. Along the first direction, the first protrusion protrudes beyond the main portion. Along the first direction, the heat dissipation fins are arranged without extending beyond the first protrusion, the top wall, the bottom wall, and the first sidewall. Driven by the fan, a smaller amount of air flowing in the first sub-duct flows into the external space of the housing, thereby improving the heat dissipation effect.

In one or more optional embodiments, the housing includes a second accommodation space. Along the second direction, the second accommodation space and the plurality of heat dissipation fins are located on two sides of the first protrusion respectively. The second accommodation space may be defined by at least a part of the second sidewall, the top wall, the bottom wall, and the first protrusion. The first protrusion can separate the second accommodation space from the air duct. When the second opening is an air inlet and the first opening is an air outlet, the first protrusion can reverse the airflow in the air duct and restrict the airflow from flowing to the second accommodation space, thereby reducing the loss of the airflow used for heat exchange, and improving the heat exchange effect. In addition, the first protrusion can provide a mounting and support basis for the components accommodated in the second accommodation space, thereby simplifying the structure.

In one or more optional embodiments, the housing assembly includes an overlay piece. The overlay piece is disposed on one side of the rear wall, the one side of the rear wall being a side facing away from the front wall. When viewed along a direction opposite to the first direction, the overlay piece covers the clearance. The overlay piece can separate the clearance from the external space of the housing, thereby reducing leakage of air from the clearance to the outside of the housing, circulating the fan-driven airflow between the clearance and the first sub-duct as much as possible, and improving the heat dissipation effect and the heat dissipation efficiency. When the fan-driven airflow flows into the air duct through the second opening, the overlay piece can work together with the bottom wall to define an initial flow direction of the airflow into the air duct, alleviate the tendency of the airflow to flow toward the external space of the housing, and improve the heat dissipation effect of the heat dissipation fins.

In one or more optional embodiments, when viewed along the direction opposite to the first direction, the overlay piece may cover the entire second sub-duct. Along the second direction, the two ends of the overlay piece extend beyond the two ends of the second sub-duct respectively.

In one or more optional embodiments, when viewed along the direction opposite to the first direction, the overlay piece covers at least a part of each of the heat dissipation fins. The overlay piece restricts the airflow that enters the first sub-duct from the clearance, thereby reducing leakage of air from the first sub-duct to the outside of the housing during airflow reversal. In this way, a majority of the reversed airflow can flow along the first sub-duct, thereby further improving the heat dissipation effect.

In one or more optional embodiments, the rear wall includes a main portion and a second protrusion. Along a direction opposite to the first direction, the second protrusion protrudes beyond the main portion. The second protrusion is configured to accommodate a heat-generating component. The plurality of heat dissipation fins include a first heat dissipation fin and a second heat dissipation fin. The first heat dissipation fin is disposed on the main portion. The second heat dissipation fin is disposed on the second protrusion. The second protrusion can increase the area of the rear wall, thereby improving the heat transfer efficiency between the first accommodation space and the rear wall and improving the heat dissipation effect. The second heat dissipation fin can increase the heat dissipation area, thereby further improving the heat dissipation effect and the heat dissipation efficiency.

In one or more optional embodiments, along the first direction, the rear wall includes a first protrusion. The first protrusion protrudes beyond the main portion. The plurality of heat dissipation fins and the second protrusion are located on one side of the first protrusion along the second direction, the one side of the first protrusion facing the first sidewall. Along the first direction, the second protrusion is arranged without extending beyond the first protrusion, the first sidewall, the top wall, and the bottom wall. The main portion, the first protrusion, the top wall, the bottom wall, and the first sidewall can jointly define a heat dissipation space. The second protrusion is entirely located within the heat dissipation space. This facilitates the formation of a flow channel on one side of the second protrusion, the one side of the second protrusion being a side facing away from the front wall, and improves the heat dissipation effect.

In one or more optional embodiments, the fan is disposed opposite to the second opening along the second direction and delivers air toward the clearance. The airflow driven by the fan can flow directly between the second opening and the clearance without a need to reverse the direction, thereby prolonging the flow path of the air in the second direction, expanding the ventilation range of the airflow, and improving the heat dissipation effect.

According to a second aspect, this application provides an electrical module. The electrical module includes the housing assembly disclosed in any one of the embodiments in the first aspect and an electrical element. The electrical element is disposed in the accommodation space.

In one or more optional embodiments, the housing includes a second accommodation space. The second accommodation space is separated from both the first accommodation space and the air duct. The electrical module includes a connection assembly disposed in the second accommodation space. The connection assembly is configured to be connected to an external device.

In one or more optional embodiments, a recess is formed on one side of the second protrusion, the one side of the second protrusion facing the front wall. At least a part of the electrical element is disposed in the recess.

In one or more optional embodiments, a thermally conductive component is disposed in the recess. The thermally conductive component is connected to the electrical element and the second protrusion.

In one or more optional embodiments, a thermal conductivity of the thermally conductive component at 25 °C may be 0.3 to 2.5 W/(m K).

According to a third aspect, this application provides an energy storage device. The energy storage device includes the electrical module disclosed in any one of the embodiments in the second aspect and at least one battery module. The electrical module and the at least one battery module are stacked along the third direction.

### BRIEF DESCRIPTION OF DRAWINGS

The following describes features, advantages, and technical effects of exemplary embodiments of this application with reference to accompanying drawings.
FIG. 1 is a schematic structural diagram of a housing assembly according to some embodiments of this application;
FIG. 2 is a schematic exploded view of the housing assembly shown in FIG. 1;
FIG. 3 is a schematic structural top view of the housing assembly shown in FIG. 1;
FIG. 4 is a cross-sectional schematic structural diagram of the housing assembly shown in FIG. 1;
FIG. 5 is a close-up view of a region A shown in FIG. 4;
FIG. 6 is a schematic structural diagram of the housing assembly shown in FIG. 1 from another viewing angle;
FIG. 7 is a close-up view of a region B shown in FIG. 6;
FIG. 8 is a schematic structural diagram of an electrical module according to some embodiments of this application;
FIG. 9 is a cross-sectional schematic structural diagram of the electrical module shown in FIG. 8; and
FIG. 10 is a schematic structural diagram of an energy storage device according to some embodiments of this application.

List of reference signs:
housing assembly 1; housing 10; front wall 11; rear wall 12; main portion 121; first protrusion 122; second protrusion 123; bottom surface 123a; recess 124; first sidewall 13; second opening 131; second sidewall 14; top wall 15; first opening 151; bottom wall 16; first accommodation space 17; air duct 18; first sub-duct 181; clearance 182; second sub-duct 183; second accommodation space 19; fan 20; heat dissipation fin 30; first end surface 30a; second end surface 30b; lateral surface 30c; first heat dissipation fin 31; second heat dissipation fin 32; overlay piece 40;
electrical module 2; electrical element 3; thermally conductive component 4; connection assembly 5;
energy storage device 6; battery module 7;
first direction X; direction X' opposite to the first direction; second direction Y; third direction Z.

### DETAILED DESCRIPTION OF EMBODIMENTS

To make the objectives, technical solutions, and advantages of some embodiments of this application clearer, the following gives a clear description of the technical solutions in some embodiments of this application with reference to the drawings in some embodiments of this application. Evidently, some described embodiments are merely a part rather than all of the embodiments of this application.

The terms such as "first", "second", and "third" used in the specification, claims, and brief description of drawings herein are intended to distinguish between different items, but are not intended to describe a specific sequence or order of precedence. In some embodiments of this application, the same reference numeral denotes the same component. For brevity, detailed descriptions of the same component are omitted in a different embodiment.

Reference to "embodiment" in this application means that a specific feature, structure or characteristic described with reference to the embodiment may be included in at least one embodiment of this application. Reference to this term in different places in the specification does not necessarily represent the same embodiment, nor does it represent an independent or alternative embodiment in a mutually exclusive relationship with other embodiments.

In the description of this application, unless otherwise expressly specified and defined, the terms such as "mount" and "connect" need to be understood in a broad sense. For example, a "connection" may be a fixed connection, a detachable connection, or an integrated connection; or may be a direct connection or an indirect connection implemented through an intermediary; or may be internal communication between two components. A person of ordinary skill in the art is able to understand the specific meanings of the terms in this application according to specific situations.

In embodiments of this application, the term "parallel" includes not only absolute parallelism, but also approximate parallelism conventionally known in engineering. The term "perpendicular" or "vertical" includes not only absolute perpendicularity, but also approximate perpendicularity conventionally known in engineering. As an example, if the angle between two directions is 85° to 95°, the two directions may be deemed perpendicular; and, if the angle between two directions is 0° to 10°, the two directions may be deemed parallel.

The following describes a housing assembly, an electrical module, and an energy storage device of this application with reference to accompanying drawings.

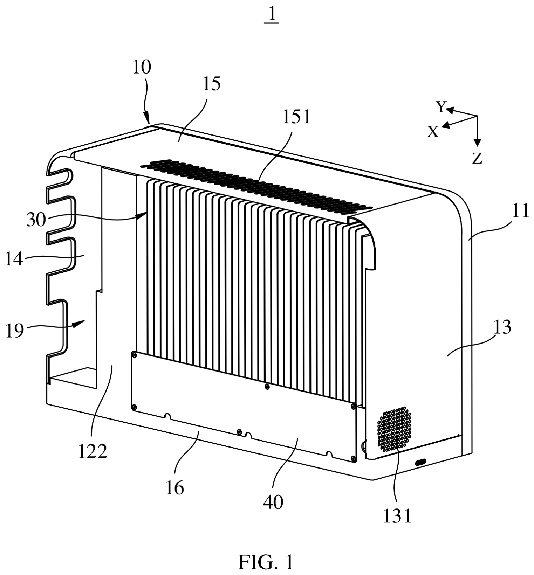

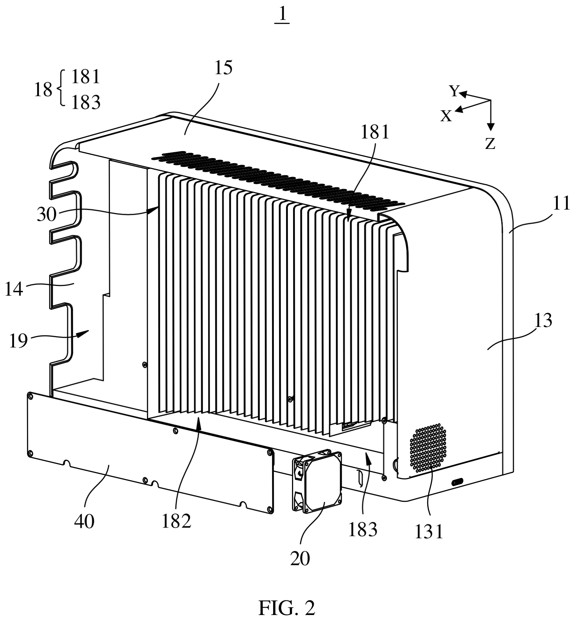

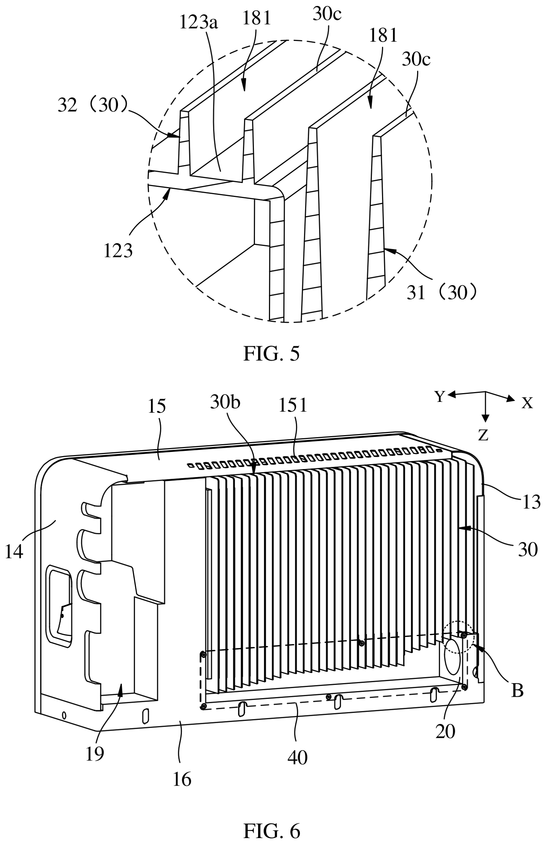

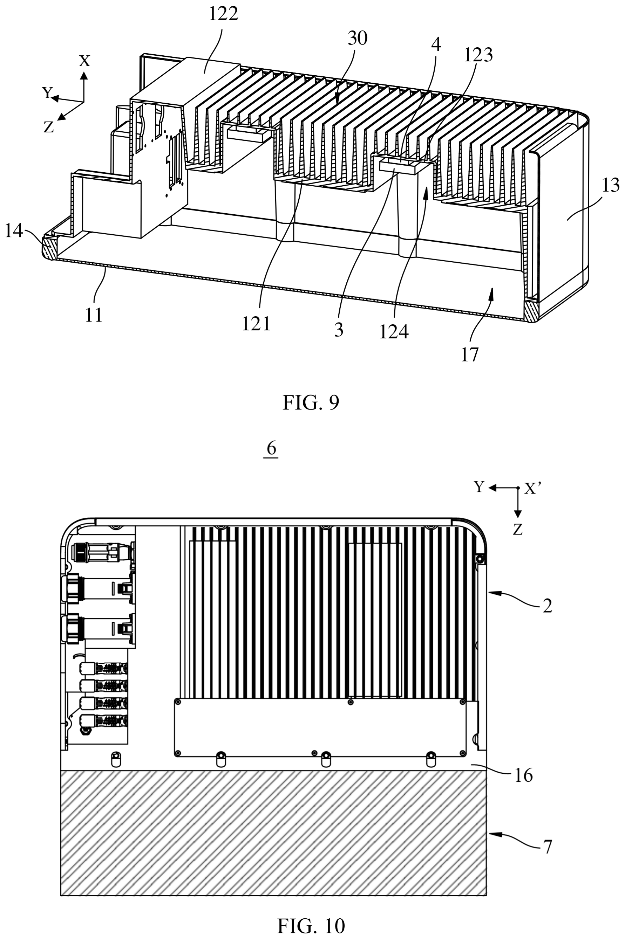

Referring to FIG. 1 to FIG. 10, an embodiment of this application provides a housing assembly 1. The housing assembly 1 may be configured to accommodate other components such as batteries and electrical elements. The components may generate an amount of heat during operation.

In some embodiments, the housing assembly 1 includes a housing 10. The housing 10 includes a front wall 11 and a rear wall 12 disposed opposite to each other along a first direction X, a first sidewall 13 and a second sidewall 14 disposed opposite to each other along a second direction Y, and a top wall 15 and a bottom wall 16 disposed opposite to each other along a third direction Z. The first direction X, the second direction Y, and the third direction Z are perpendicular to each other.

The first direction X is a direction from the front wall 11 to the rear wall 12. The second direction Y is a direction from the first sidewall 13 to the second sidewall 14. The third direction Z is a direction from the top wall 15 to the bottom wall 16.

Optionally, the first direction X and the second direction Y are parallel to the horizontal direction. The first sidewall 13 may be located to the left side of the second sidewall 14 or to the right side of the second sidewall 14. The third direction Z is parallel to the vertical direction. The top wall 15 is located above the bottom wall 16. As an example, the third direction Z may be the direction of gravity.

In some embodiments, the top wall 15 includes a first opening 151, and the first sidewall 13 includes a second opening 131.

The first opening 151 may run through the top wall 15 along the thickness direction of the top wall 15 to communicate the spaces on two sides of the top wall 15 in the thickness direction. The space on one side of the top wall 15 in the thickness direction is the external environment space in which the housing 10 is located.

In some examples, there may be a plurality of first openings 151. The plurality of first openings 151 may be spaced apart along the second direction Y.

In other examples, there may be only one first opening 151. The first opening 151 is approximately a strip-shaped opening extending along the second direction Y.

The second opening 131 may run through the first sidewall 13 along the thickness direction of the first sidewall 13 to communicate the spaces on two sides of the first sidewall 13 in the thickness direction. The space on one side of the first sidewall 13 in the thickness direction is the external environment space in which the housing 10 is located. There may be one or more second openings 131.

In some embodiments, the housing 10 includes a first accommodation space 17 and an air duct 18. Along the first direction X, the first accommodation space 17 is located between the front wall 11 and the rear wall 12. The air duct 18 is located on one side of the rear wall 12, the one side of the rear wall 12 being a side facing away from the first accommodation space 17. The air duct 18 communicates with the external space of the housing 10, the first opening 151, and the second opening 131.

The first accommodation space 17 may be configured to accommodate components such as batteries and electrical elements.

The first accommodation space 17 may be a closed space or an open space.

The first accommodation space 17 is defined by the front wall 11, the rear wall 12, the top wall 15, and the bottom wall 16. Alternatively, the first accommodation space 17 may be defined by the front wall 11, the rear wall 12, the first sidewall 13, the second sidewall 14, the top wall 15, and the bottom wall 16.

Along the first direction X, the first accommodation space 17 and the air duct 18 are located on two sides of the rear wall 12 respectively. The rear wall 12 separates the first accommodation space 17 from the air duct 18.

The heat in the first accommodation space 17 can be transferred to the air duct 18 through the rear wall 12. The rear wall 12 may be made of a material of a high thermal conductivity to improve the heat transfer efficiency, and consequently improve the heat dissipation efficiency of the first accommodation space 17.

In an embodiment of this application, the external space of the housing 10 means the external environment space in which the housing 10 is located. The air duct 18 communicates with the external space of the housing 10, that is, the air duct 18 communicates with the external environment space in which the housing 10 is located. Optionally, along the first direction X, the air duct 18 may be open to the outside of the housing 10.

The air duct 18 may directly communicate with the first opening 151 or indirectly communicate with the first opening 151 through another structure.

The air duct 18 may directly communicate with the second opening 131 or indirectly communicate with the second opening 131 through another structure.

In some embodiments, the housing assembly 1 includes a fan 20 disposed on the housing 10. The fan 20 is configured to drive an airflow into the air duct 18 through one of the first opening 151 or the second opening 131, and out of the air duct 18 through the other of the first opening 151 or the second opening 131.

One of the first opening 151 or the second opening 131 is an air inlet of the air duct 18, and the other is an air outlet of the air duct 18.

Optionally, the first opening 151 is disposed on the top wall 15. The first opening 151 is positioned higher than the second opening 131. The first opening 151 may be the air outlet of the air duct 18, and the second opening 131 may be the air inlet of the air duct 18. A hot airflow in the air duct 18 assumes a natural upward tendency, thereby improving the heat dissipation effect.

Optionally, the second opening 131 may be disposed on the first sidewall 13 at a position close to the bottom wall 16, so as to maximally prolong the flow path of the air between the first opening 151 and the second opening 131 in the third direction Z, expand the ventilation range of the air, thereby improving the heat dissipation uniformity and the heat dissipation effect.

There may be one or more fans 20. The fan 20 may be disposed outside the housing 10 or inside the housing 10. The fan 20 may be disposed close to the first opening 151 or the second opening 131.

Optionally, the fan 20 may be disposed on the first sidewall 13 or on the bottom wall 16 at a position close to the first sidewall 13. The fan 20 may blow air into the air duct 18 through the second opening 131, or draw air from the air duct 18 and blow air toward the second opening 131.

In an embodiment of this application, the first opening 151 and the second opening 131 are provided in the top wall 15 and the first sidewall 13 respectively, and the air duct 18 communicates with the first opening 151 and the second opening 131. Most of the airflow driven by the fan 20 into the air duct 18 is reversed and then flows out of the air duct 18, thereby expanding the ventilation range of the airflow, increasing the contact area between the airflow and the rear wall 12, and improving the heat dissipation effect within the first accommodation space 17. The fan 20 is suitable for dissipating heat for components arranged in various manners within the first accommodation space 17, and is widely applicable.

In some embodiments, the air duct 18 communicates with the external space of the housing 10. The heat in the first accommodation space 17 can be naturally dissipated out of the housing 10 through the rear wall 12 and the air duct 18, thereby improving the heat dissipation effect during failure or a turned-off state of the fan 20.

In some embodiments, the air duct 18 includes a plurality of first sub-ducts 181. The housing assembly 1 includes a plurality of heat dissipation fins 30 disposed on the rear wall 12. The plurality of heat dissipation fins 30 are spaced apart along the second direction Y. A first sub-duct 181 is formed between two adjacent heat dissipation fins 30. The heat dissipation fins 30 are disposed between the top wall 15 and the bottom wall 16. The heat dissipation fins 30 can increase the heat dissipation area, thereby improving the heat dissipation efficiency and the heat dissipation effect.

The dimensions of the first sub-ducts 181 along the second direction Y may be the same or different.

A plurality of first sub-ducts 181 are spaced apart along the second direction Y. Each first sub-duct 181 communicates with the external space of the housing 10, the first opening 151, and the second opening 131. The first sub-ducts 181 extend between the top wall 15 and the bottom wall 16, thereby facilitating vertical flow of the air along the first sub-ducts 181.

Top ends of the plurality of first sub-ducts 181, which are close to the first opening 151, communicate with each other. The bottom ends of the plurality of first sub-ducts 181, which are close to the second opening 131, communicate with each other.

Optionally, the heat dissipation fins 30 may be spaced apart from the top wall 15. The top ends of the plurality of first sub-ducts 181, which are close to the first opening 151, may communicate with each other through the clearance between the heat dissipation fins 30 and the top wall 15.

Optionally, the heat dissipation fins 30 may be spaced apart from the bottom wall 16. The bottom ends of the plurality of first sub-ducts 181, which are close to the second opening 131, may communicate with each other through the clearance between the heat dissipation fins 30 and the bottom wall 16.

The heat dissipation fins 30 are disposed on one side of the rear wall 12, the one side of the rear wall 12 being a side facing away from the front wall 11. The heat dissipation fins 30 may be connected to the rear wall 12 or may be integrally formed with the rear wall 12.

In some embodiments, a clearance 182 is formed between the heat dissipation fin 30 and the bottom wall 16 along the third direction Z. The clearance 182 communicates the first sub-duct 181 with the second opening 131. The heat dissipation fin 30 includes a first end surface 30a close to the bottom wall 16. The clearance 182 is formed between the first end surface 30a and the bottom wall 16.

The clearances 182 formed between the plurality of heat dissipation fins 30 and the bottom wall 16 communicate with each other. The space below the plurality of first sub-ducts 181 and the clearances 182 formed between the plurality of heat dissipation fins 30 and the bottom wall 16 together form a second sub-duct 183. The second sub-duct 183 extends to the first sidewall 13 along a direction opposite to the second direction Y, and communicates with the second opening 131.

The air duct 18 includes a second sub-duct 183. Each first sub-duct 181 communicates with the second opening 131 through the second sub-duct 183. The second sub-duct 183 is formed between the plurality of heat dissipation fins 30 and the bottom wall 16. The second opening 131 may be disposed close to the bottom wall 16, so as to communicate with the second sub-duct 183.

Along the third direction Z, the heat dissipation fin 30 includes a second end surface 30b close to the top wall 15. The first end surface 30a is disposed opposite to the second end surface 30b. The second end surface 30b may contact the top wall 15, or may be spaced apart from the top wall 15. When the second end surface 30b is spaced apart from the top wall 15, a gas confluence channel is formed between the top wall 15 and the heat dissipation fin 30, thereby facilitating the flow of gas through the first opening 151.

Along the third direction Z, the second end surfaces 30b of the plurality of heat dissipation fins 30 may be flush with each other.

In an embodiment of this application, the heat dissipation fins 30 are spaced apart from the bottom wall 16. The airflow flowing into the air duct 18 from the second opening 131 can flow to each first sub-duct 181 along the second direction Y, or the airflow flowing out from an end, close to the bottom wall 16, of each first sub-duct 181 can flow to the second opening 131. The airflow in the air duct 18 can flow through each heat dissipation fin 30, thereby expanding the ventilation range of the airflow and improving the heat dissipation uniformity and the heat dissipation effect.

In some embodiments, the first sub-duct 181 extends along the third direction Z.

Each heat dissipation fin 30 extends along the third direction Z, so that the first sub-duct 181 formed between two adjacent heat dissipation fins 30 extends along the third direction Z.

The extension direction of the first sub-duct 181 is consistent with the natural upward trend of a hot air flow, thereby reducing the resistance generated by the heat dissipation fins 30 to the airflow, increasing the air flow rate, and consequently improving the heat dissipation efficiency and the heat dissipation effect.

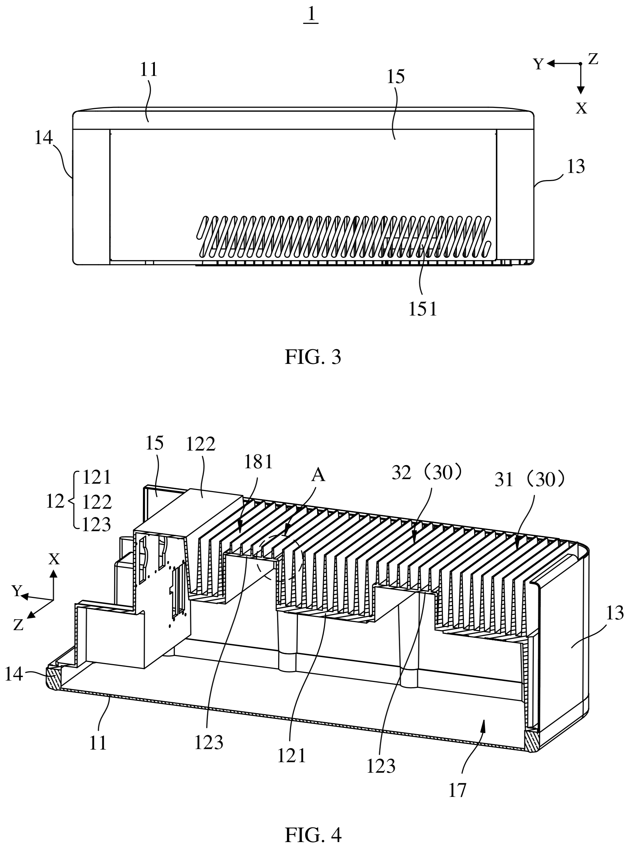

In some embodiments, the top wall 15 includes a plurality of first openings 151. The plurality of first openings 151 are spaced apart along the second direction Y. Referring to FIG. 3, when viewed along the third direction Z, the first opening 151 partially overlaps the first sub-duct 181.

The first opening 151 is located above the first sub-duct 181. The first sub-duct 181 extends along the third direction Z. A part of the airflow flowing from the first sub-duct 181 to the first opening 151 directly flows through the first opening 151, or a part of the airflow flowing from the first opening 151 to the first sub-duct 181 may directly flow into the first sub-duct 181, thereby increasing the air flow rate and improving the heat exchange effect.

In some embodiments, the first opening 151 is tilted relative to the first direction X. When viewed along the third direction Z, the first opening 151 intersects the first sub-duct 181, thereby reducing the entry of impurities into the first sub-duct 181 and alleviating the degree of dust accumulation on the heat dissipation fins 30.

The first opening 151 may be strip-shaped, circular, square, or another shape as appropriate.

In some embodiments, the dimensions of the clearances 182 formed between the plurality of heat dissipation fins 30 and the bottom wall 16 along the second direction Y assume a tendency to decreases gradually.

In some examples, the clearances 182 formed between the plurality of heat dissipation fins 30 and the bottom wall 16 are of different dimensions. The dimensions of the clearances 182 formed between the plurality of heat dissipation fins 30 and the bottom wall 16 decrease one by one along the second direction Y. For the clearances 182 formed between every two adjacent heat dissipation fins 30 and the bottom wall 16, the differences in the dimensions of the clearances may be the same as or different.

In other embodiments, the dimensions of the clearances 182 formed between the plurality of heat dissipation fins 30 and the bottom wall 16 may be partially the same. For example, along the second direction Y, the dimensions of the clearances 182 formed between the plurality of heat dissipation fins 30 and the bottom wall 16 may decrease stepwise, so that the clearances 182 formed between the heat dissipation fins 30 and the bottom wall 16 at the same gradient have the same dimension.

In yet other examples, along the second direction Y, the dimensions of the clearances 182 formed between some of the plurality of heat dissipation fins 30 and the bottom wall 16 decrease one by one, and the dimensions of the clearances 182 formed between other heat dissipation fins 30 and the bottom wall 16 are the same or decrease stepwise. The dimensions of the clearances 182 formed between the plurality of heat dissipation fins 30 and the bottom wall 16 along the second direction Y assume a tendency to decreases gradually on the whole.

The clearance 182 formed between the heat dissipation fin 30 near the second opening 131 and the bottom wall 16 is relatively large, and the clearance 182 formed between the heat dissipation fin 30 farther away from the second opening 131 and the bottom wall 16 is relatively small, thereby reducing the resistance generated by the heat dissipation fin 30 near the first sidewall 13 to the airflow, allowing the fan 20 driven airflow to flow along the second direction Y toward each first sub-duct 181, and improving the heat dissipation uniformity and the heat dissipation effect. Furthermore, the above arrangement can maximize the area of the heat dissipation fins 30 farther away from the first sidewall 13 and improve the heat dissipation effect.

In some embodiments, the rear wall 12 includes a main portion 121 and a first protrusion 122. Along the first direction X, the first protrusion 122 protrudes beyond the main portion 121.

In some embodiments, along the first direction X, the heat dissipation fin 30 is arranged without extending beyond the first protrusion 122. The heat dissipation fin 30 includes a lateral surface 30c facing away from the front wall 11. The lateral surface 30c may be flush with the first protrusion 122 or closer to the front wall 11 than the first protrusion 122.

In some embodiments, along the first direction X, the heat dissipation fin 30 is arranged without extending beyond the top wall 15. The lateral surface 30c may be flush with the top wall 15 or closer to the front wall 11 than the top wall 15.

In some embodiments, along the first direction X, the heat dissipation fin 30 is arranged without extending beyond the bottom wall 16. The lateral surface 30c may be flush with the bottom wall 16 or closer to the front wall 11 than the bottom wall 16.

In some embodiments, along the first direction X, the heat dissipation fin 30 is arranged without extending beyond the first sidewall 13. The lateral surface 30c may be flush with the first sidewall 13 or closer to the front wall 11 than the first sidewall 13.

The main portion 121, the first protrusion 122, the top wall 15, the bottom wall 16, and the first sidewall 13 can jointly define a heat dissipation space. The heat dissipation fins 30 are located in the heat dissipation space. Driven by the fan 20, a smaller amount of air flowing in the first sub-duct 181 flows into the external space of the housing 10, thereby improving the heat dissipation effect.

In some embodiments, the housing 10 includes a second accommodation space 19. The second accommodation space 19 and the plurality of heat dissipation fins 30 are located on two sides of the first protrusion 122 respectively along the second direction Y. The second accommodation space 19 may be configured to accommodate a plug, a connector, another connection assembly, or the like. The second accommodation space 19 may be a closed space or an open space. Optionally, the second accommodation space 19 is an open space. The second accommodation space 19 may be open to the outside of the housing 10 along the second direction Y, thereby making it convenient to connect the connection assembly in the second accommodation space 19 to another electrical element.

Along the second direction Y, at least a part of the first protrusion 122 may be located between the first sidewall 13 and the second sidewall 14. The second accommodation space 19 may be defined by the second sidewall 14, the top wall 15, the bottom wall 16, and at least a part of the first protrusion 122.

The second accommodation space 19 and the plurality of heat dissipation fins 30 are located on two sides of the first protrusion 122 in the second direction Y respectively. The first protrusion 122 may separate the second accommodation space 19 from the air duct 18. When the second opening 131 is an air inlet and the first opening 151 is an air outlet, the first protrusion 122 can reverse the airflow in the air duct 18 and restrict the airflow from flowing to the second accommodation space 19, thereby reducing the loss of the airflow used for heat exchange, and improving the heat exchange effect. In addition, the first protrusion 122 can provide a mounting and support basis for the components accommodated in the second accommodation space 19, thereby simplifying the structure.

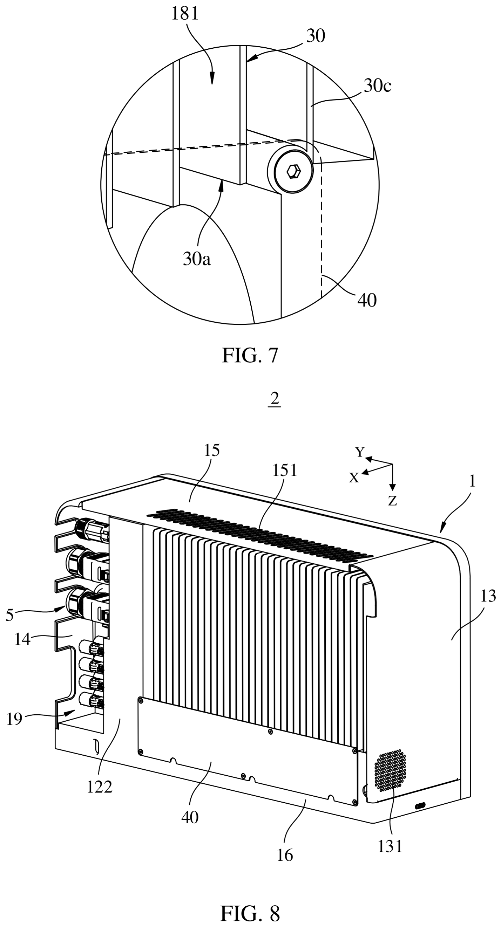

In some embodiments, the housing assembly 1 includes an overlay piece 40. The overlay piece 40 is disposed on one side of the rear wall 12, the one side of the rear wall 12 being a side facing away from the front wall 11. Referring to FIG. 8, when viewed along a direction X' opposite to the first direction X, the overlay piece 40 covers the clearance 182.

The overlay piece 40 can separate the clearance 182 from the external space of the housing 10, thereby reducing leakage of air from the clearance 182 to the outside of the housing 10, circulating the fan 20 driven airflow between the clearance 182 and the first sub-duct 181 as much as possible, and improving the heat dissipation effect and the heat dissipation efficiency. When the fan 20 driven airflow flows into the air duct 18 through the second opening 131, the overlay piece 40 can work together with the bottom wall 16 to define an initial flow direction of the airflow into the air duct 18, alleviate the tendency of the airflow to flow toward the external space of the housing 10, and improve the heat dissipation effect of the heat dissipation fins 30.

The overlay piece 40 may be connected to the first protrusion 122, the bottom wall 16, and/or the first sidewall 13 by screw connection, bonding, snap-on connection, or another means as appropriate. The overlay piece 40 may be connected to at least a part of the heat dissipation fins 30 by screw connection. Optionally, the overlay piece 40 may abut the heat dissipation fins 30.

Referring to FIG. 8, when viewed along the direction X' opposite to the first direction X, the overlay piece 40 covers the entire second sub-duct 183. Along the second direction Y, the two ends of the overlay piece 40 extend beyond the two ends of the second sub-duct 183 respectively.

In some embodiments, referring to FIG. 8, when viewed along the direction X' opposite to the first direction X, the overlay piece 40 covers at least a part of each heat dissipation fin 30. Optionally, the overlay piece 40 covers the first end surface 30a of each heat dissipation fin 30.

The heights of the first end surfaces 30a of the plurality of heat dissipation fins 30 along the third direction Z may be the same or different. The overlay piece 40 covers the first end surfaces 30a of all heat dissipation fins 30.

The overlay piece 40 may just cover the first end surface 30a of the heat dissipation fin 30, or may additionally cover a lower section of the heat dissipation fin 30, the lower section being close to the first end surface 30a.

The overlay piece 40 restricts the airflow that enters the first sub-duct 181 from the clearance 182, thereby reducing leakage of air from the first sub-duct 181 to the outside of the housing 10 during airflow reversal. In this way, a majority of the reversed airflow can flow along the first sub-duct 181, thereby further improving the heat dissipation effect.

In some embodiments, the rear wall 12 includes a main portion 121 and a second protrusion 123. Along the direction X' opposite to the first direction X, the second protrusion 123 protrudes beyond the main portion 121. The second protrusion 123 is configured to accommodate a heat-generating component. In an embodiment of this application, the heat-generating component means a component that generates heat during operation.

The second protrusion 123 may be disposed on one side of the first protrusion 122, the one side of the first protrusion 122 facing the first sidewall 13. Along the second direction Y, the second protrusion 123 and the first protrusion 122 may be spaced apart.

There may be one or more second protrusions 123. When there are a plurality of second protrusions 123, the plurality of second protrusions 123 may be spaced apart along the second direction Y. The amounts by which the second protrusions 123 protrude beyond the main portion 121 may be the same or different.

The second protrusion 123 can increase the area of the rear wall 12, thereby improving the heat transfer efficiency between the first accommodation space 17 and the rear wall 12 and improving the heat dissipation effect.

In some embodiments, the plurality of heat dissipation fins 30 include a first heat dissipation fin 31 and a second heat dissipation fin 32. The first heat dissipation fin 31 is disposed on the main portion 121, and the second heat dissipation fin 32 is disposed on the second protrusion 123. In these embodiments of this application, the second heat dissipation fin 32 disposed on the second protrusion 123 can increase the heat dissipation area, thereby further improving the heat dissipation effect and the heat dissipation efficiency.

Along the second direction Y, the first heat dissipation fins 31 may be spaced apart from the second protrusion 123. Along the first direction X, the heat dissipation fin 31 extends beyond the second protrusion 123. The second protrusion 123 is entirely located within the heat dissipation space in which the plurality of heat dissipation fins 30 are located. A flow channel can be defined between the first heat dissipation fin 31 adjacent to the second protrusion 123 and the bottom surface 123a of the second protrusion 123, the bottom surface facing away from the front wall 11. The flow channel may form a part of the air duct 18, thereby improving the heat dissipation effect.

In some embodiments, the second heat dissipation fin 32 may be connected to a bottom surface 123a of the second protrusion 123, the bottom surface facing away from the front wall 11; or the second heat dissipation fin may be integrally formed with the second protrusion 123.

The lateral surface 30c of the second heat dissipation fin 32 may be flush with the lateral surface 30c of the first heat dissipation fin 31, both lateral surfaces 30c facing away from the front wall 11.

In some embodiments, along the second direction Y, the plurality of heat dissipation fins 30 and the second protrusion 123 are located on one side of the first protrusion 122, the one side of the first protrusion 122 facing the first sidewall 13. Along the first direction X, the second protrusion 123 is arranged without extending beyond the first protrusion 122. Optionally, the second protrusion 123 includes a bottom surface 123a facing away from the front wall 11. The bottom surface 123a may be closer to the front wall 11 than the first protrusion 122.

In some embodiments, along the first direction X, the second protrusion 123 is arranged without extending beyond the first sidewall 13. Optionally, the bottom surface 123a is closer to the front wall 11 than the first sidewall 13.

In some embodiments, along the first direction X, the second protrusion 123 is arranged without extending beyond the top wall 15. Optionally, the bottom surface 123a is closer to the front wall 11 than the top wall 15.

In some embodiments, along the first direction X, the second protrusion 123 is arranged without extending beyond the bottom wall 16. Optionally, the bottom surface 123a is closer to the front wall 11 than the bottom wall 16.

The main portion 121, the first protrusion 122, the top wall 15, the bottom wall 16, and the first sidewall 13 can jointly define a heat dissipation space. The second protrusion 123 is entirely located within the heat dissipation space. This facilitates the formation of a flow channel on one side of the second protrusion 123, the one side of the second protrusion 123 being a side facing away from the front wall 11, and improves the heat dissipation effect.

In some embodiments, the fan 20 is disposed opposite to the second opening 131 along the second direction Y and delivers air toward the clearance 182. Optionally, a part of the fan 20 is located in the second opening 131.

In some examples, there may be only one fan 20, and the fan 20 may be disposed on one side of the first sidewall 13, the one side of the first sidewall 13 facing the second sidewall 14; or the fan may be disposed on one side of the first sidewall 13, the one side of the first sidewall 13 being a side facing away from the second sidewall 14.

In other examples, there may be two fans 20, and the two fans 20 are disposed on two sides of the first sidewall 13 along the second direction Y respectively.

The fan 20 may be supported on and connected to the bottom wall 16, or may be connected to the first sidewall 13, or may be connected to both the bottom wall 16 and the first sidewall 13 at the same time.

The fan 20 may include an air intake and an air outlet. Of the air intake and the air outlet of the fan 20, one may directly communicate with the second opening 131, and the other may be directed toward the clearance 182. The airflow driven by the fan 20 can flow directly between the second opening 131 and the clearance 182 without a need to reverse the direction, thereby prolonging the flow path of the air in the second direction Y, expanding the ventilation range of the airflow, and improving the heat dissipation effect.

A rotation axis of the fan 20 is parallel to the second direction Y. The air outlet of the fan 20 is oriented in the horizontal direction, thereby reducing the risk that the fan 20 is eroded by dust and/or rainwater, and increasing the service life of the fan 20.

An embodiment of this application provides an electrical module 2. The electrical module 2 includes the housing assembly 1 disclosed in any one of the embodiments of this application and an electrical element 3. The electrical element 3 is disposed in the accommodation space 17.

There may be one or more electrical elements 3.

The electrical elements 3 may be arranged in the first accommodation space 17 in any suitable manner.

Heat generated by the electrical elements 3 during operation can be transferred to the air duct 18 through the rear wall 12 of the housing assembly 1. Most of the airflow driven by the fan 20 into the air duct 18 is reversed and then flows out of the air duct 18, thereby expanding the ventilation range of the airflow, increasing the contact area between the airflow and the rear wall 12, and improving the heat dissipation effect.

In some embodiments, a recess 124 is formed on one side of the second protrusion 123, the one side of the second protrusion 123 facing the front wall 11. At least a part of the electrical element 3 is disposed in the recess 124.

In some embodiments, there may be one electrical element 3. At least a part of the electrical element 3 is disposed in the recess 124.

In other embodiments, there may be a plurality of electrical elements 3. At least a part of at least one electrical element 3 may be disposed in the recess 124.

At least a part of the recess 124 may be formed by the enclosure of the second protrusion 123. The recess 124 can provide an accommodation space for the electrical elements 3, thereby saving space. Furthermore, the two sides of the recess 124 along the second direction Y and the side facing away from the front wall 11 along the first direction X are all contiguous to the rear wall 12. The heat generated by the electrical elements 3 can be transferred to the rear wall 12 in plurality of directions and then carried away by the flowing air in the air duct 18 on the other side of the rear wall 12, thereby improving the heat dissipation efficiency and the heat dissipation effect.

Optionally, the electrical element 3 may include an inductor. The inductor generates a lot of heat. Disposing at least a part of the inductor in the recess 124 is conducive to improving the heat dissipation efficiency and the heat dissipation effect of the inductor.

In some embodiments, a thermally conductive component 4 is disposed in the recess 124. The thermally conductive component 4 is connected to the electrical element 3 and the second protrusion 123.

Optionally, the thermally conductive component 4 may be a thermal adhesive. The thermally conductive component 4 is bonded to the electrical element 3 and the second protrusion 123.

Optionally, the thermal conductivity of the thermally conductive component 4 may be greater than the thermal conductivity of the rear wall 12.

In some embodiments, the thermal conductivity of the thermally conductive component 4 at 25 °C may be 0.3 to 2.5 W/(m K).

The thermally conductive component 4 is of a relatively high thermal conductivity, thereby increasing the speed at which the heat generated by the electrical elements 3 is transferred to the rear wall 12, and improving the heat dissipation effect.

In some embodiments, the housing 10 includes a second accommodation space 19. The second accommodation space 19 is separated from both the first accommodation space 17 and the air duct 18.

Optionally, the second accommodation space 19 may be separated from the air duct 18 by the first protrusion 122, and the second accommodation space 19 may be separated from the first accommodation space 17 by a part of the rear wall 12, or may be separated from the first accommodation space 17 by another sidewall.

In some embodiments, the electrical module 2 includes a connection assembly 5 disposed in the second accommodation space. The connection assembly 5 is configured to be connected to an external device.

The connection assembly 5 may include a plurality of connection terminals. The connection terminals may be, for example, an aviation connector or another electrical connector.

The connection assembly 5 is disposed in the second accommodation space 19. The connection assembly 5 is separated from both the electrical elements 3 in the first accommodation space 17 and the air duct 18, thereby reducing interference between the connection assembly 5 and the air duct 15.

An embodiment of this application provides an energy storage device 6. The energy storage device 6 includes an electrical module 2 disclosed in any one of the embodiments of this application and at least one battery module 7. The electrical module 2 and the at least one battery module 7 are stacked along the third direction Z.

At least one battery module 7 is disposed below the electrical module 2. The battery module 7 adjacent to the electrical module 2 may be connected to the bottom wall 16.

The airflow driven by the fan 20 can promptly take away the heat generated by the electrical module 2, thereby reducing the heat transfer from the electrical module 2 to the battery module 7 and reducing the impact on the battery module 7. In addition, the airflow driven by the fan 20 facilitates heat dissipation from the battery module 7 adjacent to the electrical module 2, thereby improving the reliability of the battery module 7.

The energy storage device 6 disclosed in an embodiment of this application may be an energy storage container, an energy storage cabinet, or the like.

The energy storage device disclosed in an embodiment of this application is applicable to energy storage stations, wind power generation systems, solar power generation systems, mobile power systems, temporary power supply systems, or the like. The energy storage device can store electrical energy as needed and output the electrical energy when appropriate.

Although this application has been described with reference to exemplary embodiments, various improvements may be made to some embodiments without departing from the scope of this application, and the components of this application may be replaced with equivalents. Particularly, to the extent that no structural conflict exists, various technical features mentioned in various embodiments may be combined in any manner. This application is not limited to some specific embodiments disclosed herein, but includes all technical solutions falling within the scope of the claims.

## Claims

1. A housing assembly (1), comprising a housing (10) and a fan (20) disposed on the housing (10);
the housing (10) comprises a front wall (11) and a rear wall (12) disposed opposite to each other along a first direction (X), a first sidewall (13) and a second sidewall (14) disposed opposite to each other along a second direction (Y), and a top wall (15) and a bottom wall (16) disposed opposite to each other along a third direction (Z); and the first direction (X), the second direction (Y), and the third direction (Z) are perpendicular to each other;
the top wall (15) comprises a first opening (151), and the first sidewall (13) comprises a second opening (131);
the housing (10) comprises a first accommodation space (17) and an air duct (18); along the first direction (X), the first accommodation space (17) is located between the front wall (11) and the rear wall (12); the air duct (18) is located on one side of the rear wall (12), the one side of the rear wall (12) being a side facing away from the first accommodation space (17); the air duct (18) communicates with an external space of the housing (10), the first opening (151), and the second opening (131); and
the fan (20) is configured to drive an airflow into the air duct (18) through one of the first opening (151) or the second opening (131), and out of the air duct (18) through the other of the first opening (151) or the second opening (131).

2. The housing assembly (1) according to claim 1, wherein the air duct (18) comprises a plurality of first sub-ducts (181);
the housing assembly (1) comprises a plurality of heat dissipation fins (30) disposed on the rear wall (12), the plurality of heat dissipation fins (30) are spaced apart along the second direction (Y), a first sub-duct (181) is formed between two adjacent heat dissipation fins (30), and the heat dissipation fins (30) are disposed between the top wall (15) and the bottom wall (16); and
along the third direction (Z), a clearance (182) is formed between the heat dissipation fins (30) and the bottom wall (16), and the clearance (182) communicates the first sub-duct (181) with the second opening (131).

3. The housing assembly (1) according to claim 2, wherein a dimension of the clearance (182) formed between the plurality of heat dissipation fins (30) and the bottom wall (16) along the second direction (Y) decreases gradually.

4. The housing assembly (1) according to claim 2 or 3, wherein the rear wall (12) comprises a main portion (121) and a first protrusion (122), and the first protrusion (122) protrudes beyond the main portion (121) along the first direction (X); and
along the first direction (X), the heat dissipation fins (30) are arranged without extending beyond the first protrusion (122), the top wall (15), the bottom wall (16), and the first sidewall (13).

5. The housing assembly (1) according to claim 4, wherein the housing (10) comprises a second accommodation space (19); and along the second direction (Y), the second accommodation space (19) and the plurality of heat dissipation fins (30) are located on two sides of the first protrusion (122) respectively.

6. The housing assembly (1) according to any one of claims 2 to 5, wherein the housing assembly (1) comprises an overlay piece (40), and the overlay piece (40) is disposed on one side of the rear wall (12), the one side of the rear wall (12) being a side facing away from the front wall (11); and when viewed along a direction opposite to the first direction (X'), the overlay piece (40) covers the clearance (182).

7. The housing assembly (1) according to claim 6, wherein, when viewed along the direction opposite to the first direction (X'), the overlay piece (40) covers at least a part of each of the heat dissipation fins (30).

8. The housing assembly (1) according to any one of claims 2 to 7, wherein the rear wall (12) comprises a main portion (121) and a second protrusion (123); along a direction opposite to the first direction (X'), the second protrusion (123) protrudes beyond the main portion (121), and the second protrusion (123) is configured to accommodate a heat-generating component; and
the plurality of heat dissipation fins (30) comprise a first heat dissipation fin (31) and a second heat dissipation fin (32), the first heat dissipation fin (31) is disposed on the main portion (121), and the second heat dissipation fin (32) is disposed on the second protrusion (123).

9. The housing assembly (1) according to claim 8, wherein the rear wall (12) comprises a first protrusion (122); along the first direction (X), the first protrusion (122) protrudes beyond the main portion (121); and
along the second direction (Y), the plurality of heat dissipation fins (30) and the second protrusion (123) are located on one side of the first protrusion (122), the one side of the first protrusion facing the first sidewall (13); and
along the first direction (X), the second protrusion (123) is arranged without extending beyond the first protrusion (122), the first sidewall (13), the top wall (15), and the bottom wall (16).

10. The housing assembly (1) according to any one of claims 2 to 9, wherein along the second direction (Y), the fan (20) is disposed opposite to the second opening (131) and is configured to deliver air toward the clearance (182).

11. The housing assembly (1) according to claim 2, wherein a space below the plurality of first sub-ducts (181) and the clearance (182) formed between the plurality of heat dissipation fins (30) and the bottom wall (16) together form a second sub-duct (183); along a direction opposite to the second direction (Y'), the second sub-duct (183) extends to the first sidewall (13), and communicates with the second opening (131).

12. The housing assembly (1) according to claim 2, wherein when viewed along the third direction (Z), the first opening (151) intersects the first sub-duct (181).

13. An electrical module (2), wherein the electrical module (2) comprising:
the housing assembly (1) according to any one of claims 1 to 12; and
an electrical element (3), disposed in the first accommodation space (17).

14. The electrical module (2) according to claim 13, wherein the housing (10) comprises a second accommodation space (19), and the second accommodation space (19) is separated from both the first accommodation space (17) and the air duct (18); and
the electrical module (2) comprises a connection assembly (5) disposed in the second accommodation space (19), and the connection assembly (5) is configured to be connected to an external device.

15. An energy storage device (6), wherein the energy storage device (6) comprising:
the electrical module (2) according to any one of claims 13 to 14; and
at least one battery module (7), wherein the electrical module (2) and the at least one battery module (7) are stacked along the third direction (Z).
